# EUROPEAN PATENT SPECIFICATION

(11) **EP 1 076 108 B1**
(45) Date of publication and mention of the grant of the patent: **06.04.2005**
(21) Application number: 99810713.0
(22) Date of filing: 09.08.1999
(51) Int. Cl.: C23C 4/02, C23C 14/02

(54) **Process for treating the surface of a component, made from a Ni based superalloy, to be coated**
Verfahren zur Behandlung einer zu beschichtenden Oberfläche einer Komponente aus einer Nickelbasissuperlegierung
Procédé pour le traitement d'une surface d'un component à base d'un superalliage de Nickel, à couvrir

(43) Date of publication of application: 14.02.2001
(73) Proprietor: ALSTOM Technology Ltd, 5400 Baden (CH)
(72) Inventor: Bögli, Andreas, 5430 Wettingen (CH); Fernihough, John, Dr., 5408 Ennetbaden (CH); Tönnes, Christoph, 5200 Brugg (CH)

(56) References cited:
- EP-A- 0 298 309
- EP-A- 0 813 930
- FR-A- 2 380 354
- US-A- 5 071 486
- US-A- 5 598 968

## Description

### FIELD OF INVENTION

The invention relates to a process for treating the surface of a component prior to applying a coating, wherein the component is a newly manufactured part, made of a Ni based superalloy and designed for high temperature services, e.g. components for gas turbine engines, and both the component and the coating include the elements Al and/or Cr.

### STATE OF THE ART

Components designed for the use in the area of high temperature, e.g. blades or vanes of a gas turbine, are usually coated with resistant coatings. The coating protects the base material against corrosion and oxidation due to the thermal effect of the hot environment and consists of an alloy mostly using the elements Al and Cr, e.g. MCrAIY. During operation of the component, the coating is slowly oxidized and/or corroded away, and at some point in time is either completely removed or reaches a minimum design limit which is no longer suitable for continued operation.

Components subject to coating wear and/or other damage during service are removed from service at regular intervals for repair and/or reconditioning during which any residual coating is stripped, various repairs are made, and a new coating applied. In addition to this, it is possible that new components are improperly coated during manufacturing and must have the coating stripped in order for an acceptable quality coating to be applied.

In the past for the coating more Al is used in a higher content to allow better oxidation resistance at increased temperatures. As base material often used is an superalloy e.g. Ni based. Such Ni based superalloy is disclosed in the patent US 5,759,301. A problem occurs due to the fact that content of Al and Cr in the coating in comparison with the base material is significantly higher. In the follow an undesired intermallic phase gamma prime (Ni₃Al) occurs between the coating and the base material.

Ni based superalloys are typically heat treated so as to precipitate cubic gamma prime particles surrounded by a softer gamma matrix. At very high volume fractions, gamma prime tends to form in continuous rafts or bands which offer much reduced resistance to crack growth and creep compared to the dispersed condition as mentioned above. The phenomena of overheating during service of Ni based superalloy components, which leads to rafting of gamma prime into semicontinuous bands even at the normal gamma prime volume fractions of these superalloys. Components exhibiting this microstructure are unsuitable for further service because of the weakening effects of the gamma prime rafts.

When a typical MCrAIY coating is applied to the surface of a component made of a Ni base alloy, a diffusion heat treatment is normally required in order to ensure a high quality bond between coating and base material. During the heat treatment and subsequent operation of the component at high temperatures, Al and Cr from the coating diffuse into the surface of the base material forming an "interdiffusion zone" in which the continuos bands of gamma prime often precipitate. The gamma prime bands form primarily due to the enrichment of the "interdiffusion zone" with Al which directly contribute to Ni₃Al formation, and also due to the presence of Cr which increases the thermodynamic activity of Al. The "interdiffusion zone" after extended time in service can extend up to approximately 200 µm penetration into the component beyond the coating/component-interface.

It is understood that very often the cracks leading to coating spallation occur not in the interface base-material/coating itself but in the brittle interdiffusion zone, along the gamma prime bands.

This effect has been recognised in the patent US 5,556,713, which offers a diffusion barrier formed by ion implantation of Re atoms onto the surface of the base material before coating. The purpose of the diffusion barrier is to stop the harmful diffusion of Al and Cr into the base material and forming the brittle continuous bands of gamma prime.

This effect is also indirectly recognised by patent US 5,728,227 where a method for removing a diffusion coating from a Nickel based alloy is disclosed. It is been done by mechanically removing the outer coating to expose the diffused coating inner portion and by depleting the extra Al left over in the surface layer of the component, which is equal to the "interdiffusion zone". The component may have run in service, or simply have been improperly coated and in need of a repair coating. According to the patent the method can be considered to reverse the prior diffusion of Al into the surface portion from a previously applied coating. It also applies the process only to previously coated or service run components.
Furthermore the mechanical means of the prior art of patent US 5,728,227 may impart considerable residual stresses on the component surface. While that is not of great concern for components manufactured with an equiaxed grain structure, components with a directionally solidified structure (columnar grains or single crystal) are extremely prone to recrystallization from such residual stresses if heat treated to regenerate a desired distribution of gamma prime. Recrystallization in such components profoundly decreases their resistance to failure under creep and cyclic loading, and usually results in their being scrapped. This problem has actually been recognized in the patent US 5,598,968, in which a solution for the recrystallization problem is presented by means of causing a precipitation of carbides in the surface layers of the component. However, the carbide precipitation requires an expensive and time consuming heat treatment and ultimately alters the originally intended composition and structure of the base alloy of the component.

The current state of the art for preparing previously coated parts is to strip the coating off the part either mechanically or chemically, clean the surface by various means including transfer arc cleaning, and re-coat. US Patent 5,728,227 only claims for the mechanical stripping option. Although the mechanical stripping is a distinct advantage for parts (e.g. in aeroengines) which are destined to undergo several re-coating operations during their service lives, there is little advantage for those parts which will only be subject to two or three such re-coat operations and in particular no advantage for newly coated parts with defective coatings in need of a repair coating. Such newly coated parts would have a very small interdiffusion zone.

EP-A2-0 813 930 describes a method for repairing a coated nickel base superalloy article with the steps of removing the coating from the outer surface of the article, of exposing the article to a reducing mixture of gases and finally of recoating the article. The surface treatment is needed only for the purpose of preparing for the weld repair of cracks or for the removal of hot corrosion products, such as metal sulfides.

As for new components, apart from exotic solutions to the diffusion zone problem such as the diffusion boundary layer, the established art in the preparation before coating may comprise surface cleaning operations such as grit blasting, surface grinding, etching and/or transfer arc cleaning. However all of these processes are only designed to remove unwanted inclusions or contaminants from the surface of the component, and will have no significant effect on the chemical composition of the surface layer. No other methods are given which would avoid the formation of the brittle interdiffusion zone.

### SUMMARY OF THE INVENTION

It is the aim of the present invention to overcome the presented disadvantages. The invention solves the task to create a process of preparing a newly manufactured component designed for high temperature services, e.g. Ni based superalloy, for the coating to prevent an interdiffusion zone between component and coating. Both of them, the component and the coating, include the elements Al and/or Cr.

With the invention a solution for the task was found for preparing a component designed for high temperature services, e.g. a Ni based superalloy, for the coating characterised in that the outer surface of the component will be depleted of any one or a combination of Al, Cr and Ti and the coating will be applied directly onto the depleted surface.

The advantage of process is that with the creation of a layer depleted from Al and/or Ti and/or Cr in the base material of a newly manufactured part before coating impedes the formation of a continuous layer of gamma prime even when Al and Cr diffuse in as normal during the diffusion heat treatment after coating, or during the subsequent operation of the component at elevated temperatures. It depletes with advantage the surface of the component of any one or a combination of Al, Cr and Ti in a depth up to of 500 µm, with a preferred range of a depth from 20 µm up to 200 µm.

### DESCRIPTION OF PREFERRED EMBODIMENT

The invention refers to a process of preparing a newly manufactured component designed for high temperature services for coating. Thus components are used for example as blade or vane in gas turbines. Normally they consist of a base material with a coating. For example as base material is often used a Ni based superalloy, as thermal barrier coating MCrAIY or similar may be used.

The creation of a layer depleted from Al and/or Ti and/or Cr on the outer surface of the base material of a newly manufactured component before coating impedes the formation of a continuous layer of gamma prime even when Al and Cr diffuse in as normal during the diffusion heat treatment after coating, or during the subsequent operation of the component at elevated temperatures. The process depletes the surface of the component of any one or a combination of Al, Cr and Ti in a depth up to of 500 µm, with a preferred range of a depth from 20 µm up to 200 µm.

The depletion of the elements are accomplished by a cleaning process which exposes reactive ions as fluoride to the component surface. Known for these aims are for example the Dayton process or a Ti-Coating process. Such depletion processes are for example described in the patent EP 34 041 or US 4,188,237. A process for cleaning the surface of an superalloy from oxides, which is also disclosed in the patents US 4,405,379 or US 4,098,450, will deplete the outer surface of the component as a side-effect.

Furthermore, the depletion step may be carried out, as an example, by adding to the furnace assembly any number of the following constituents in any combination or ratios: hydrogen fluoride, fluorine, hydrogen, Teflon, helium, argon, nitrogen, chromium fluoride, ammonium fluoride, methane or any fluorocarbon or hydrocarbon. The additions of various constituents, combinations thereof or ratios thereof, may be changed continuously or at any distinct time during the processing of the component and/or at any temperature to optimize the effects of depletion. An additional vacuum heat treatment may be carried out afterwards to remove residual metal flourides.

The depletion step may also be carried out under such times and so as to also yield a solutioning and/or precipitation hardening heat treatment for the component.

The component surface may also be chemically or mechnically cleaned after the depletion process in order to remove any residual salts or other contaminants, however the depleted surface layer must not be removed, which would be happen by grit blasting, for example.

The coating operation will take place directly on the depleted layer.

If there are inner cooling passages of the component, they may be shielded from the gases used to deplete the surface so that there is no depletion of the Al, Cr or Ti from the inner cooling passage surfaces. This is especially desirable when the inner surfaces are aluminized or otherwise treated for enviroment resistance.

The advantage of the present invention is that, due to the initial depletion of gamma prime forming elements in the surface layer of the component, there will be a minimization of elimination of the continuous banding of gamma prime in the interdiffusion zone during the diffusion heat treatment and / or the service life of the component. It is also expected that due to this special preparation, higher than normal Al content coatings may be used, leading to longer coating lives approaching those of the lifetime of the component itself, which may remove the necessity of costly re-coating operations during repair of the component.

## Claims

1. A process for treating the surface of a component prior to applying a coating, wherein the component is a newly manufactured part, made of a Ni based superalloy, and both the component and the coating include the elements Al and/or Cr,
**characterised by**
depleting the surface of the component of any one or a combination of Al, Ti, and Cr before applying the coating of the component directly on the depleted surface.

2. The process of claim 1,
**characterised by**
depleting the surface of the component to a depth up to 500 µm.

3. Process of claim 2,
**characterised by**
depleting the surface of the component to a depth with a range from 20 to 200 µm.

## Patentansprüche

1. Verfahren zur Behandlung der Oberfläche eines Bauteils vor dem Aufbringen einer Beschichtung, wobei es sich bei dem Bauteil um ein neu angefertigtes Teil aus einer Ni-Basis-Superlegierung handelt und sowohl das Bauteil als auch die Beschichtung die Elemente Al und/oder Cr enthalten,
**dadurch gekennzeichnet, daß** man die Oberfläche des Bauteils an Al, Ti und/oder Cr abreichert, bevor man die Beschichtung des Bauteils direkt auf die abgereicherte Oberfläche aufbringt.

2. Verfahren nach Anspruch 1,
**dadurch gekennzeichnet, daß** man die Oberfläche des Bauteils bis zu einer Tiefe von bis zu 500 µm abreichert.

3. Verfahren nach Anspruch 2,
**dadurch gekennzeichnet, daß** man die Oberfläche des Bauteils bis zu einer Tiefe im Bereich von 20 bis 200 µm abreichert.

## Revendications

1. Procédé de traitement de la surface d'un composant préalablement à l'application d'un revêtement, dans lequel le composant est une pièce récemment fabriquée, à base d'un superalliage de nickel, et le composant et le revêtement comportent tous deux les éléments aluminium et/ou chrome,
**caractérisé par**
l'appauvrissement de la surface du composant en l'un quelconque ou une combinaison des éléments aluminium, titane et chrome avant l'application du revêtement du composant directement sur la surface appauvrie.

2. Procédé selon la revendication 1,
**caractérisé par**
l'appauvrissement de la surface du composant sur une profondeur allant jusqu'à 500 µm.

3. Procédé selon la revendication 2,
**caractérisé par**
l'appauvrissement de la surface du composant sur une profondeur allant de 20 à 200 µm.
